# EUROPEAN PATENT SPECIFICATION

(11) **EP 2 063 532 B1**
(45) Date of publication and mention of the grant of the patent: **25.03.2020**
(21) Application number: 08169043.0
(22) Date of filing: 13.11.2008
(51) Int. Cl.: H03K 17/96

(54) **Multiple touch switch**
Mehrere Schalter enthaltender Berührungsschalter
Commutateur à effleurement comprenant plusieurs commutateurs

(30) Priority: 14.11.2007 BE 200700549
(43) Date of publication of application: 27.05.2009
(73) Proprietor: Basalte BVBA, 9820 Merelbeke (BE)
(72) Inventor: Arnout, Klaas Nikolaas Ignace, 9820 Merelbeke (BE)
(74) Representative: De Clercq, Ann G. Y.

(56) References cited:
- DE-A1-102004 026 836
- US-A1- 2005 156 483
- US-A1- 2006 177 212
- US-A1- 2007 024 591

## Description

This invention concerns a multiple touch switch for operating lighting, curtains, roller shutters or other functions in a house.

The switch works by touching the surface, without the need for a mechanical component. This touching can be detected, for example, by an electronic circuit based on capacitive technology.

US2006/0177212, US2007/0024591 and US2005/0156483 are examples of multiple touch switches known in the art.

### Functional description of the general function

The switch according to the invention contains several (e.g., 4) touch surfaces. Each of these surfaces takes care of a different function. For example, each surface can correspond to a different light circuit.

The switch also contains an additional general function. By touching several surfaces simultaneously or within a pre-defined time, the additional function can be activated.

The additional function enables turning on of lights (which can consist of different circuits) in one movement when entering into a room. By touching more than one surface, the lights can be turned off also when leaving the room.

This is in contrast to the current systems in which only a single button in a multiple switch can be used to turn lights on or off or in which a separate button for each light circuit has to be pressed.

This invention facilitates a quicker and more intuitive system for turning lights on or off without conscious mental activity and without having to look for the correct button, and nevertheless without compromising the advantage of operating each light circuit separately. This limits the number of actions considerably and increases its user-friendliness.

For example, when using two touch surfaces in a multiple switch, lights can be turned on or off by touching the entire surface (i.e. the two touch surfaces). If, for example, only one of the touch surfaces is touched, it can be used to increase the intensity of the light and the other touch surface can be used to dim the light. By touching the two touch surfaces simultaneously, the light can, for example, be turned off again.

### Example (without any limitation)

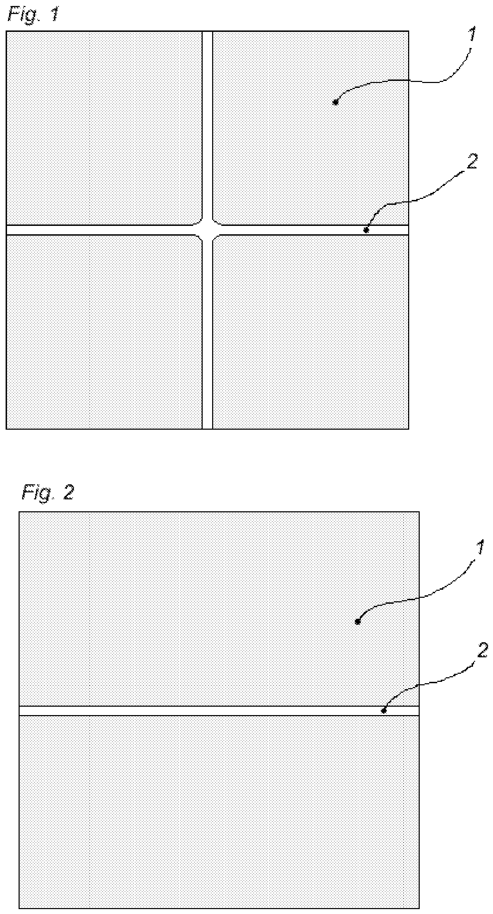

In order to clarify the features of this invention, the following example describes - without any limitation - a preferred model of a fourfold and a twofold touch switch. In this example, the multiple touch switch (Figure 1) can consist of 4 touch surfaces (1). These touch surfaces are sufficiently large to make it very convenient for the user.

An electronic circuit of the capacitive type detects touching. This electronic circuit is set to sufficient sensitivity so that only a slight touch is needed. Touching is detected on the entire touch surface, both in the centre of the touch surface and up to the corners.

A connecting piece (2) of a transparent material separates the four touch surfaces from each other. Due to this, a return message can be sent if a touch surface is touched by means of a RGB LED (Light Emitting Diode).

By touching a single touch surface (1), the switch can be illuminated, for instance with white light. By touching several surfaces (with the general function) the switch can be illuminated, for example, with orange light. In the darkness, the switch can also remain illuminated making it easily visible.

By touching several surfaces, all the lights in a room can be turned on or off in a pre-determined preferred sequence. By touching a single touch surface (1) for example, individual light connections can be operated.

Another example is a multiple touch switch (Figure 2) that consists of 2 touch surfaces (1). Also in this case, the touch surfaces are sufficiently large to make it very convenient for the user and the electronic circuit is set to sufficient sensitivity. Touching is detected on the entire touch surface, both in the centre of the touch surface and up to the corners.

A connecting piece (2) of a transparent material separates the two touch surfaces from each other. Due to this, a return message can be sent if a touch surface is touched by means of a RGB LED (Light Emitting Diode).

By touching a single touch surface (1), the switch can be illuminated, for example, with white light. By touching several surfaces (with the general function) the switch can be illuminated, for example, with orange light. In the darkness, the switch can also remain illuminated making it easily visible.

By touching several surfaces, all the lights in a room can be turned on or off in a pre-determined preferred sequence. By touching a single touch surface (1) for example, individual light connections can be operated.

In case of a single light circuit, by touching both touch surfaces, the light circuit can be turned on or off. By touching the upper surface, emitted light will be increased, while by touching the bottom surface, the emitted light will be dimmed.

## Claims

1. A touch switch, comprising at least two touch-sensitive surfaces (1), wherein the touch switch further comprises an electronic circuit configured to generate an electronic signal to perform an associated individual function when each of the at least two touch-sensitive surfaces (1) is individually touched, and wherein the electronic circuit is further configured to generate an electronic signal to perform an additional function when multiple touch-sensitive surfaces (1) are touched simultaneously or within a pre-defined time period,
**characterised in that** at least one of the individual functions comprises the operation of lights, light circuits, curtains or roller shutters,
andwherein the additional function comprises turning lights on and/or off, and **in that**
the at least two touch-sensitive surfaces (1) are separated by a connecting piece of transparent material (2), which is configured to send a return message when one or more of the touch-sensitive surfaces (1) are touched, wherein the return message is sent by illumination of the connecting piece of transparent material (2) by a LED.

2. The touch switch according to claim 1, wherein the electronic circuit is configured to detect touching on the entire surface of the at least two touch-sensitive surfaces (1).

3. The touch switch according to any one of claims 1 or 2, wherein each individual function comprises turning individual lights on and/or off, and wherein the additional function comprises turning multiple lights on and/or off.

4. The touch switch according to any of the preceding claims, wherein at least one of the individual functions comprises a change in intensity of one or more lights.

5. The touch switch according to any of the preceding claims, wherein at least one of the individual functions and/or the additional function comprises a colour change of the LED.

6. The touch switch according to any of the preceding claims, wherein the touch switch comprises exactly two touch-sensitive surfaces (1).

7. The touch switch according to any of the preceding claims, wherein the touch switch comprises exactly four touch-sensitive surfaces (1).

## Patentansprüche

1. Kontaktschalter, der wenigstens zwei berührungsempfindliche Oberflächen (1) umfasst, wobei der Kontaktschalter ferner eine elektronische Schaltung umfasst, die konfiguriert ist, ein elektronisches Signal zu erzeugen, um eine zugehörige Einzelfunktion auszuführen, wenn jede der wenigstens zwei berührungsempfindlichen Oberflächen (1) einzeln berührt wird, und wobei die elektronische Schaltung ferner konfiguriert ist, ein elektronisches Signal zu erzeugen, um eine zusätzliche Funktion auszuführen, wenn mehrere berührungsempfindliche Oberflächen (1) gleichzeitig oder innerhalb einer zuvor definierten Zeitspanne berührt werden,**dadurch gekennzeichnet, dass**
wenigstens eine der Einzelfunktionen den Betrieb von Lichtern, Lichtschaltern, Vorhängen oder Jalousien umfasst,
und wobei die zusätzliche Funktion das Ein- und/oder Ausschalten von Lichtern umfasst,
und dadurch, dass
die wenigstens zwei berührungsempfindlichen Oberflächen (1) durch ein Verbindungsstück aus lichtdurchlässigem Material (2) getrennt sind, das konfiguriert ist, eine Rückmeldung zu senden, wenn eine oder mehrere der berührungsempfindlichen Oberflächen (1) berührt werden, wobei die Rückmeldung durch Beleuchten des Verbindungsstücks aus lichtdurchlässigem Material (2) durch eine LED gesendet wird.

2. Kontaktschalter nach Anspruch 1, wobei die elektronische Schaltung konfiguriert ist, eine Berührung auf der gesamten Oberfläche der wenigstens zwei berührungsempfindlichen Oberflächen (1) zu detektieren.

3. Kontaktschalter nach einem der Ansprüche 1 oder 2, wobei jede Einzelfunktion das Ein- und/oder Ausschalten einzelner Lichter umfasst und wobei die zusätzliche Funktion das Ein- und/oder Ausschalten mehrerer Lichter umfasst.

4. Kontaktschalter nach einem der vorhergehenden Ansprüche, wobei wenigstens eine der Einzelfunktionen eine Änderung der Intensität eines oder mehrerer Lichter umfasst.

5. Kontaktschalter nach einem der vorhergehenden Ansprüche, wobei wenigstens eine der Einzelfunktionen und/oder die zusätzliche Funktion eine Farbänderung der LED umfasst.

6. Kontaktschalter nach einem der vorhergehenden Ansprüche, wobei der Kontaktschalter genau zwei berührungsempfindliche Oberflächen (1) umfasst.

7. Kontaktschalter nach einem der vorhergehenden Ansprüche, wobei der Kontaktschalter genau vier berührungsempfindliche Oberflächen (1) umfasst.

## Revendications

1. Interrupteur à effleurement, comprenant au moins deux surfaces sensibles à l'effleurement (1), l'interrupteur à effleurement comprenant en outre un circuit électronique configuré pour générer un signal électronique pour accomplir une fonction individuelle associée lorsque chacune des au moins deux surfaces sensibles à l'effleurement (1) est effleurée individuellement, et le circuit électronique étant configuré en outre pour générer un signal électronique pour accomplir une fonction supplémentaire lorsque de multiples surfaces sensibles à l'effleurement (1) sont effleurées simultanément ou au sein d'une période de temps prédéfinie,
**caractérisé en ce que**
au moins une des fonctions individuelles comprend la commande d'éclairages, d'un circuit d'éclairage, de rideaux ou des volets roulants, et la fonction supplémentaire comprenant l'allumage et/ou l'extinction d'éclairages,
et **en ce que**
les au moins deux surfaces sensibles à l'effleurement (1) sont séparées par une pièce de liaison en matériau transparent (2), laquelle est configurée pour envoyer un message de retour lorsqu'une ou plusieurs des surfaces sensibles à l'effleurement (1) sont effleurées, le message de retour étant envoyé par illumination de la pièce de liaison en matériau transparent (2) au moyen d'une LED.

2. Interrupteur à effleurement selon la revendication 1, dans lequel le circuit électronique est configuré pour détecter l'effleurement de la surface entière des au moins deux surfaces sensibles à l'effleurement (1).

3. Interrupteur à effleurement selon l'une quelconque des revendications 1 ou 2, dans lequel chaque fonction individuelle comprend l'allumage et/ou l'extinction d'éclairages individuels, et dans lequel la fonction supplémentaire comprend l'allumage et/ou l'extinction de multiples éclairages.

4. Interrupteur à effleurement selon l'une quelconque des revendications précédentes, dans lequel au moins une des fonctions individuelles comprend un changement d'intensité d'un ou de plusieurs éclairages.

5. Interrupteur à effleurement selon l'une quelconque des revendications précédentes, dans lequel au moins une des fonctions individuelles et/ou la fonction supplémentaire comprennent/comprend un changement de couleur de la LED.

6. Interrupteur à effleurement selon l'une quelconque des revendications précédentes, lequel interrupteur à effleurement comprend exactement deux surfaces sensibles à l'effleurement (1).

7. Interrupteur à effleurement selon l'une quelconque des revendications précédentes, lequel interrupteur à effleurement comprend exactement quatre surfaces sensibles à l'effleurement (1).
